# EUROPEAN PATENT SPECIFICATION

(11) **EP 0 502 437 B1**
(45) Date of publication and mention of the grant of the patent: **03.09.1997**
(21) Application number: 92103452.6
(22) Date of filing: 28.02.1992
(51) Int. Cl.: G01R 31/36, H02J 7/14

(54) **A device for determining the charge condition of batteries, in particular on board a vehicle**
Apparat zur Bestimmung der Ladung einer Batterie, insbesondere in einem Fahrzeug
Dispositif pour déterminer la condition de charge d'une batterie, notamment dans un véhicule

(30) Priority: 05.03.1991 IT TO910153
(43) Date of publication of application: 09.09.1992
(73) Proprietor: IVECO FIAT S.p.A., 10156 Torino (IT)
(72) Inventor: Baldi, Giuseppe, I-10100 Torino (IT); Brandenstein, Heinz, W-7901 Illerrieden (DE)
(74) Representative: Jorio, Paolo, Dr. Ing.

(56) References cited:
- EP-A- 0 027 254
- DE-A- 2 630 033
- DE-C- 3 814 551
- US-A- 3 852 732

## Description

The present invention relates to a device for determining the charge condition of batteries, in particular on board a vehicle, as defined in the preamble of claim 1.

It is known that in motor vehicles having electrical loads which are installed on board, which are supplied even when the internal-combustion engine is inoperative and the consumption of which is not negligible (for example a refrigeration unit in the case of commercial vehicles), it may happen that when the charging installation is not working, i.e. when the internal-combustion engine is inoperative, the batteries become discharged below a value which is sufficient to ensure autonomy of operation of the batteries themselves so as to meet the requirements of the vehicle (for example starting the engine).

In particular, it is known that the charge level of batteries (which is proportional to the density of the electrolyte in the batteries) is unequivocally correlated to the no-load voltage of the batteries themselves and, therefore, by measuring the latter it is possible to determine the condition of the batteries.

A device for measuring and displaying the charge condition of batteries of the type defined in the preamble of claim 1 is disclosed in DE-A-2 630 033, wherein the measure is carried out when no load is drawing current from the batteries. To this and, the known device comprises sensor means for detecting any current from the battery to a load and for interrupting or preventing the measure in case of current detection. However, the load is not disconnected from the battery when the measure is to be carried out.

Therefore, it is the object of the present invention to provide a device which is able to determine the state of charge of batteries so as to prevent it from falling below a predetermined limit value, under circumstances in which electric loads are surely switched on and the charging installation is inoperative.

According to the present invention, a device is provided for determining the charge condition of batteries, in particular on board a vehicle, as defined in claim 1.

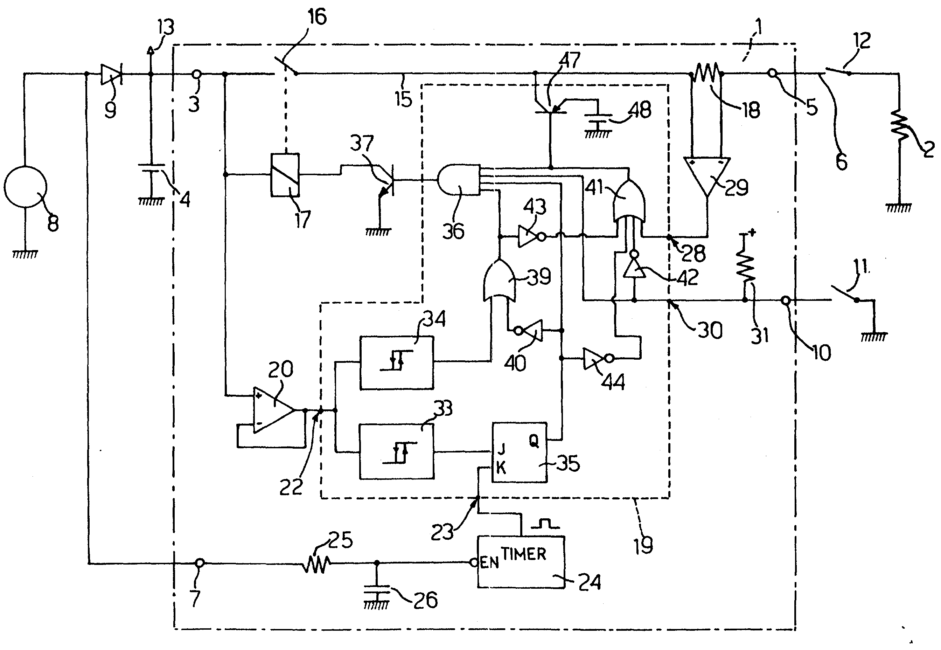

With a view to a better understanding of the present invention, a preferred embodiment thereof will be described below non-restrictively by way of example and with reference to the accompanying drawing, in which the single Figure represents an equivalent electrical diagram of the device according to the invention, applied to a commercial vehicle provided with a tilting cab.

Referring now to the single Figure, the device according to the invention is indicated by the reference numeral 1 and is inserted in the power supply circuit for a load 2, for example a refrigeration unit. In particular, the device 1 has a first terminal 3 which is intended to be connected to the batteries (which are indicated in the diagram by a voltage generator 4 and which supply the electric circuit of the vehicle, represented schematically in the drawing by an arrow 13), a second terminal 5 intended to be connected to the power supply line 6 for the load 2, a third terminal 7 intended to be connected between the generator unit 8 of the vehicle (alternator with bridge rectifier) and the batteries 4, upstream of a blocking diode 9 (connected to the anode terminal of the generator 8 and to the cathode terminal of the batteries 4), and a fourth terminal 10 which is connected to earth via a further switch 11 operated by the tilting system for the cab of the motor vehicle (not shown in the drawing). The load 2 is, in turn, connected to the power supply line 6 via its own switch 12.

The device 1 comprises a line 15 which mutually connects the terminals 3 and 5, along which are disposed a contact 16 of a relay 17 and a small resistor 18. Additionally, the device 1 comprises a logic control unit 19 adapted to control the more or less excited state of the relay 17. For this purpose, there is provided an amplifier 20 with total feedback and operating as a buffer, its non-inverting input being connected to the line 15 and its output connected to an input 22 of the logic unit 19. Additionally, the logic unit 19 has a second input 23 connected to the output of a timer 24 having an enabling input EN connected to the terminal 7 via an RC delay unit. Specifically, the RC unit comprises a resistor 25 inserted between the terminal 7 and the enabling input of the timer 24 and a capacitor 26 disposed between said enabling input and earth. The logic unit 19 additionally comprises a third input 28 connected to the output of a comparator 29 whose inputs are connected to the two terminals of the resistor 18 and a fourth input 30 connected to the terminal 10 and, via a resistor 31, a supply voltage of logical value.

The main function of the logic unit 19 is to determine the charge condition of the batteries under no-load (load cut out) when the engine is inoperative. For this purpose, when notified by the timer 24, the logic unit 19 disconnects the load 2, by opening the contact 16, and measures the voltage of the battery. If the no-load voltage exceeds a predetermined threshold, the logic unit 19 reconnects the load, or else it maintains the load without supply until the battery voltage returns to an acceptable value. In addition, preferably the logic unit 19 also determines the charge condition of the batteries during the operation of the engine (charging phase of the batteries) so as to check the correct operation of the alternator, and maintains the relay 17 de-energised if the load is not connected to the power supply line (switch 12 open) or if the vehicle cab is tilted for maintenance and/or repair purposes (switch 11 closed).

To carry out these operations, in accordance with the drawing the input 22 of the logic unit 19 is connected to the input of two hysteresis comparators 33, 34 (for example, Schmitt triggers). Advantageously, the hysteresis comparator 33, which is intended to monitor the voltage of the batteries under no-load, has a lower threshold voltage (below which the comparator changes over from the high level to the low level) equal to about 24.3 V and an upper threshold voltage (upon exceeding which the comparator changes over from the low level to the high level) equal to about 25.5 V. The comparator 34, which is intended to monitor the voltage of the batteries with the load connected, has a lower threshold voltage equal to about 22 V and an upper threshold voltage equal to about 24.3 V.

The output of the comparator 33 is connected to the input J of a J-K flip-flop 35 whose reset input K is connected to the output of the timer 24. The output Q of the flip-flop 35 is connected to an input of a logic product or AND gate 36 with four inputs, the output of which is connected to the base terminal of a NPN-type control transistor 37, the collector terminal of which is connected to the relay 17 and the emitter terminal of which is connected to earth. Additionally, the relay 17 is connected to the line 15 and, specifically, it is disposed between said line and earth via the transistor 37.

The output of the comparator 34 is connected to an input of a logic sum or OR gate 39 having a second input connected to the output Q of the flip-flop 35, via an inverter 40, and an output connected to a second input of the AND gate 36. A third input of the AND gate 36 is connected to the input 30 of the logic unit 19, while a fourth input of the said gate 36 is connected to the output of an OR gate 41. The latter has four inputs connected respectively to the input 28 of the logic unit 19, to the input 30 via an inverter 42, to the output of the OR gate 39, via an inverter 43, and to the output Q of the flip-flop 35 via a further inverter 44. Finally, the output of the OR gate 41 is connected to the base terminal of a PNP-type transistor 47, the collector terminal of which is connected to the power supply line 15 and the emitter terminal of which is connected to a low-value direct voltage generator 48.

The mode of operation of the device described is as follows:

When the load 2 is connected (switch 12 closed) and the charging unit is inoperative (the generator 8 is not-generating the charging voltage of the batteries 4), reverse bias is applied to the diode 9 and, therefore, there is low enabling signal at the input EN of the timer 24. In these conditions, the timer transmits to the input 23 of the logic unit 19 a normally low signal which has high pulses (verifying pulses) at predetermined intervals of time. Assuming that the vehicle cab is not tilted (switch 11 open), these pulses, one of which is generated every hour for example, initiate the phase for determining the no-load charge condition of the batteries. In fact, if is assumed that at the preceding verifying terminal the output voltage of the batteries was higher than the lower threshold (and therefore that the output Q of the flip-flop 35 was high), when a high pulse arrives at its reset input K the output Q changes over to the low level. The low signal at the output Q is taken to the input of the AND gate 36 whose output becomes low, thereby cutting out the transistor 37 and de-energising the relay 16 which, therefore, opens the contact 16. Therefore, the load is no longer connected. At the same time, the low signal at the output of the flip-flop 35 is inverted by the inverters 40 and 44 and maintains high the outputs of the OR gates 39, 41 independently of the outputs of the load comparator 34 and of the load detector 29. Consequently, the transistor 47 is cut off, thereby separating the generator 48 from the power supply line 15, and the sections for monitoring the voltage with the load connected (components 34, 39) and for monitoring the presence of the load (components 29, 41, 47 and 48) are disabled. In this phase, the voltage present in the line 15, upstream of the switch 16, is measured by the no-load comparator 33. If this voltage is higher than the lower threshold, the output of the comparator 33 is maintained high, whereby at the end of the pulse generated by the timer 24 the output Q of the flip-flop 35 changes over again to the high level, thus causing the change-over of the AND gate 36 to the high level, the cutting-in of the transistor 37, the reenergising of the relay 17, the closing of the contact 16 and the restoring of the power supply to the load. Therefore, the inverters 40 and 44 generate low signals at their output, which enable the respective OR gates 39 and 41 so as to make possible power supply to the AND gate 36 with possible disabling signals generated by the comparators 34 and 29, as will be explained later on.

On the contrary, if during the time in which the high verifying pulse is present at the input 23, the comparator detects that the no-load voltage of the battery has dropped below its lower threshold, the output of the comparator 33 changes over to the low level, whereby the output Q of the flip-flop is kept low even at the end of the verifying pulse. In this condition the load remains disconnected, so as to preserve a residual capacity of the batteries, for example 30-40 %, so that in any case the starting operation of the engine can take place.

This situation is maintained while the voltage in the battery remains below the upper threshold of the comparator 33, i.e. until the starting of the engine induces, via the generator or alternator 8, the charging of the batteries 4 to the upper threshold value. In particular, the voltage generated by the generator 8 and fed (with a delay correlated to the time constant of the RC unit 25, 26) to the enabling input EN of the timer 24 prevents the latter from generating further verifying pulses. Therefore, a constant low signal is present at the input K of the flip-flop 35. In the interim, the voltage generated by the generator 8 charges the batteries 4. As soon as the voltage in the batteries 4 exceeds the upper threshold of the no-load comparator 33, the comparator 33 changes over to the high level as does the output Q of the flip-flop 35, whereby the load is connected again by closure of the contact 16. Accordingly, no-load verification is not effected again until the engine is switched off. When this occurs, the diode 9 is cut out, the voltage at the terminal 7 is nullified, as it is at the enabling input EN of the timer 24, after a delay caused by the discharge time of the capacitor 26. Consequently, the timer 24 resumes the periodic generation of verifying pulses.

As already mentioned, as long as the output of the flip-flop 35 is kept low, the output of the comparator 34 is ineffective. On the contrary, when the flip-flop 35 has a high output (time interval between two no-load verifications with a negative result or during the operation of the engine, with the batteries 4 charged to a value such that the output of the no-load comparator 33 is kept high), the section for verifying the voltage with the load connected is enabled. In fact, in this case the OR gate 39 is enabled to transmit the respective monitoring pulses to the AND gate 36. In particular, as long as the load comparator 34 detects that the voltage with the load connected is above its lower threshold, its output is kept high, as is the output of the OR gate 39, thereby maintaining the enabling at the AND gate 36 to energise the relay 17. However, when the comparator 34 detects the voltage of the batteries 4 with the load connected has dropped below its lower threshold, it changes over to the low level which is conveyed to the input of the OR gate 39 and, therefore, to the AND gate 36. Consequently, the contact 16 is opened and the load 2 is disconnected as long as the voltage in the batteries 4 is maintained below the upper threshold of the comparator 34. As soon as the voltage in the batteries 4 exceeds said upper threshold as a result of the engine being operative, the comparator 34 changes over, thereby allowing the contact 16 to be closed. It will be noted that, during this phase, the no-load comparator 33 is disabled in that, in the absence of a high no-load verifying pulse at the input K of the flip-flop 35, the output Q of the latter is kept high even when the output of the comparator 33 becomes low. Consequently, the section of the logic unit 19 including the components 34, 39 preferably monitors the charge condition of the batteries 4 with the load connected in the periods of time between one no-load verification and the succeeding one, as well as during the operation of the engine.

The logic unit 19 cuts off the power supply to the load also in the event of the cab being tilted, so as to prevent unnecessary consumption. In fact, under normal conditions (cab not tilted), the switch 11 disposed between the earth and the input 30 is open and the input 30 is connected to a positive supply voltage through the resistor 31 and, therefore, has a high logic level. However, when the cabin is tilted, the switch 11 is closed and connects the input 30 to earth. In these circumstances, the AND gate 36 receives a low signal at its input and it changes over, thereby inducing the opening of the contact 16, irrespectively of the charge condition of the batteries 4. However, the input of the AND gate 36 immediately returns to the high level as soon as the switch 11 is opened as a result of the cab being returned to its normal position.

However, the comparator 29 determines the presence of the load and de-energises the relay 17 in the absence of the load, so as to reduce the consumption which is caused by the relay itself and which would be unjustifiable. In fact, as long as the load is connected to the power supply line 15, the supply current flowing through the resistor 18 generates a certain drop therein which is detected by the comparator 29, the output of which is thus high, as is the output of the OR gate 41. The output of the OR gate 41 remains high even when the load 2 is disconnected by the opening of the contact 16 owing to the intervention of one of the comparators 33, 34 during the periodic verification or as a result of the tilting of the cab. In fact, in these circumstances, although the inputs of the comparator 29 are at the same potential and the comparator 29 generates a low signal at its output, one of the output signals of the inverters 42-44 is high. However, when the load 2 is disconnected from its power supply line 6 (switch 12 open), the output of the comparator 29 is low, as are the outputs of the inverters 42-44, whereby the OR gate 41 transmits a low signal to the AND gate 36 which controls the de-energising of the relay 17. The change-over to the low level of the output of the OR gate 41 causes the cutting-in of the transistor 47 which connects the generator 48 to the supply line. Nothing happens while the switch 12 is open because, since the switches 12 and 16 are open, current cannot flow along the line 15. On the contrary, as soon as the load 2 is reconnected as result of the closing of the switch 12, the generator 48 (low value) can supply the load for an instant, the current can flow along the line 15 and the resistor 18 generates a voltage drop which is detected by the comparator 29. Accordingly, the latter changes to the high level, thereby allowing the relay to be energised, the contact 16 to be closed and the transistor 47 to be re-opened. The load is thus supplied normally by the batteries.

The device described above has the following advantages.

As a result of the periodic verification of the load condition of the batteries in the inoperative condition of the engine and possible disconnection of the load, it is possible to prevent the batteries from becoming discharged to such an extent that they are no longer able to ensure that the vehicle can be started.

The monitoring of the charge condition of the batteries with the load connected obviates inadequate power supply to the load in the event of abnormal operation of the generator 8 (thereby providing a monitoring function in respect of the operation of the latter, the condition of which can also be indicated to the driver by means of displays or lights which illuminate upon intervention of the comparator 34 in the presence of the disabling signal at the terminal 7). Specifically, this function is particularly useful if the load comprises a refrigeration unit, in which an inadequate power supply situation can lead to breakdown caused by vibrations of the compressor, with the possibility of fracture of the freon delivery pipe.

The device has reduced consumption, so as not to aggravate any possible state of partial discharge of the batteries, owing to the low consumption of the actual electronic section and to the disconnection of the relay in all situations in which monitoring is not required or the load is disconnected (switch 12 open).

The device is simple, economical, easily put into effect and easily installed on the vehicle.

It is evident that device described and illustrated here could undergo various modifications, without thereby departing from the scope of the present invention. In particular, it is emphasized that the logic unit 19 may be widely varied with respect to that shown, while retaining the described functions of monitoring and disconnecting the load; in particular, the logic unit 19 can be put into effect by means of a so-called programmable logic circuit or, possibly, an intelligent microprocessor unit.

Furthermore, the circuit shown in the drawing may be completed by visual warning systems to indicate to the driver the operating condition of the batteries and generator (alternator).

## Claims

1. A device (1) for determining the charge condition of batteries (4), in particular on board of a vehicle having an engine, comprising:
- a first terminal (3) for connection to the batteries (4);
- a second terminal (5) for connection to a load (2);
- switch means (16, 17) which are controlled between an open and a closed condition, inserted between said first and second terminals (3, 4) and having a control terminal to receive an opening signal;
- a logic unit (19) for verifying the charge condition when the batteries (4) are not connected to the load (2) , including first measuring means (33) connected to said first terminal (3) for measuring the voltage at the batteries; and
- drive means (37) connected to said control terminal of said switch means for opening said switch means (16, 17), **characterized in that** said logic unit (19) comprises an input (23) for receiving verifying pulses, means (36) connected to said drive means (37) for activating said drive means (37) for opening said switch means (16, 17) each time the logic unit (19) receives one of said verifying pulses, and means (35) for generating an output signal representing the output of said first measuring means (33) obtained with said switch means (16, 17) being in the open condition.

2. A device according to claim 1, characterized in that it comprises timer means (24) connected to said input (23) of said logic unit (19) for periodically activating said drive means (37) and thereby bringing said switch means (16, 17) into said open condition.

3. A device according to claim 2, characterized in that said means for activating (36) comprises a logic gate receiving an input signal from said timer means (24) and having an output connected to an input of said drive means (37) and in that said drive means (37) has an output connected to said control terminal of said switch means (16, 17) for generating said opening signal upon receiving a disconnection signal at its input.

4. A device according to claim 3, characterized in that said means (35) for generating an output signal comprises a delay means having a first input (J) connected to said first measuring means (33), a second input (K) connected to an output of said timer means (24) and an output (Q) connected to said logic gate (36), said delay means (35) being enabled by said timer means to generate at the output a first disconnection signal and to maintain said first disconnection signal as long as the voltage at the batteries (4) is below a predetermined threshold.

5. A device according to one of claims 2 to 4, characterized in that said timer means (24) has an own enabling input (EN) receiving a disabling signal during a charging phase of the batteries (4).

6. A device according to claim 4 or 5, characterised in that said switch means (16, 17) comprise a relay (17) having energizing inputs connected to said first terminal (3) and the output of said drive means (37) and provided with a switching contact (16) disposed between said first and second terminals (3, 5).

7. A device according to any one of claims 3 to 6, characterised in that it comprises second measuring means (34, 39) connected to said first terminal (3) and having a disabling input receiving said first disconnection signal, said second measuring means (34, 3.9) being adapted to measure the voltage at the batteries (4) in the absence of said first disconnection signal.

8. A device according to claim 7, characterised in that said second measuring means (34, 39) have an output connected to an input of said logic gate (36) and are adapted to generate a second disconnection signal at said output when the voltage at the batteries (4) is below a predetermined threshold.

9. A device according to any one of claims 3 to 8, characterised in that it comprises third measuring means (29, 41) connected to said second terminal (5) and having a disabling input receiving said first disconnection signal and an output connected to an input of said logic gate (36), said third measuring means (29, 41) being adapted to measure the resistance of the load (2) and to generate a third disconnection signal in the absence of load.

10. A device according to any one of claims 3 to 9, for application to a motor vehicle provided with a tilting cab, characterised in that it comprises a monitoring input (10) receiving a further disconnection signal when the cab is tilted, said monitoring input (10) being connected to said logic gate (36).

11. A device according to any one of the preceding claims, characterised in that said first measuring means comprise a hysteresis comparator (33) having a lower threshold and an upper threshold representing respective battery voltage levels at which the load (2) is to be disconnected from and reconnected to the batteries (4).

12. A device according to any one of claims 4 to 11, characterised in that said delay means comprise a bistable memory element (35) having a setting input (J) connected to said first measuring means (33), a resetting input (K) connected to said timer means (24) and an output (Q) connected to said logic gate (36).

13. A device according to any one of claims 7 to 12, characterised in that said second measuring means (34, 39) comprise a hysteresis comparator (34) provided with a lower threshold and an upper threshold representing respective battery voltage levels at which the load (2) is to disconnected from and reconnected to the batteries (4).

## Patentansprüche

1. Eine Einrichtung (1) zur Bestimmung des Ladezustandes von Batterien (4), insbesondere an Bord eines Fahrzeuges mit einem Motor, umfassend:
- einen ersten Anschluß (3) zum Anschließen an die Batterien (4) ;
- einen zweiten Anschluß (5) zum Anschließen an eine Last (2) ;
- Schalt-Mittel (16, 17), die zwischen einem offenen Zustand und einem geschlossenen Zustand gesteuert werden, die zwischen den ersten und zweiten Anschlüssen (3, 4) eingefügt sind und einen Steueranschluß aufweisen, um ein Öffnen-Signal zu empfangen;
- eine Logik-Einrichtung (19) zum Überprüfen des Ladezustandes, wenn die Batterien (4) nicht mit der Last verbunden sind (2), umfassend ein erstes Meßmittel (33), das mit dem ersten Anschluß (3) verbunden ist, um die Spannung an den Batterien zu messen, und
- ein Steuermittel (37), das mit dem Steueranschluß der Schaltmittel verbunden ist, um die Schaltmittel (16, 17) zu öffnen,
**dadurch gekennzeichnet, daß**
die Logik-Einrichtung (19) einen Eingang (23) aufweist, um Testpulse zu empfangen, ein Mittel (36), das mit Steuermittel (37) verbunden ist, um das Steuermittel (37) zu aktivieren, um die Schaltmittel (16, 17) jedesmal, wenn die Logik-Einrichtung (19) einen Testpuls empfängt zu öffnen, und ein Mittel (35) um ein Ausgangssignal zu erzeugen, das den Ausgang von dem ersten Meßmittel (33) darstellt, das erhalten wird, wenn die Schaltmittel (16, 17) in einem offenen Zustand sind.

2. Eine Anordnung gemäß Anspruch 1,
**dadurch gekennzeichnet, daß**
sie ein Zeitgebermittel (24) umfaßt, das mit Eingang (23) von der Logik-Einrichtung (19) verbunden ist, um periodisch das Steuermittel (37) zu aktivieren und dadurch die Schaltmittel (16, 17) in den offenen Zustand zu bringen.

3. Eine Einrichtung gemäß Anspruch 2,
**dadurch gekennzeichnet, daß**
das Mittel zum Aktivieren (36) ein Logik-Gatter umfaßt, das ein Eingangssignal von dem Zeitgebermittel (24) empfängt, und einen Ausgang aufweist, der mit einem Eingang von dem Steuermittel (37) verbunden ist, und in dem das Steuermittel (37) einen Ausgang aufweist, der mit dem Steueranschluß von den Schaltmitteln (16, 17) verbunden ist, um das Öffnen-Signal bei dem Empfang eines Abtrenn-Signals an seinem Eingang zu erzeugen.

4. Eine Einrichtung gemäß Anspruch 3,
**dadurch gekennzeichnet, daß**
das Mittel zum Erzeugen eines Ausgangssignals (35) ein Verzögerungsmittel aufweist, das einen ersten Eingang (J) aufweist, der mit dem ersten Meßmittel (33) verbunden ist, einen zweiten Eingang (K), der mit einem Ausgang des Zeitgebermittels (24) verbunden ist, und einen Ausgang (Q), der mit dem Logik-Gatter (36) verbunden ist, wobei das Verzögerungsmittel (35) von dem Zeitgebermittel eingeschalten wird, um an dem Ausgang ein erstes Abtrenn-Signal zu erzeugen und das erste Abtrenn-Signal so lange aufrechtzuerhalten, so lange die Spannung an den Batterien (4) unter einem vorbestimmten Schwellwert ist.

5. Eine Einrichtung gemäß einem der Ansprüche 2 bis 4,
**dadurch gekennzeichnet, daß**
das Zeitgebermittel (24) einen eigenen Freigabeeingang (EN) aufweist, der ein Abschaltsignal während einer Ladephase von den Batterien (4) empfängt.

6. Eine Einrichtung gemäß Anspruch 4 oder 5,
**dadurch gekennzeichnet, daß**
die Schaltmittel (16, 17) ein Relais (17) umfassen, das Einschalteingänge aufweist, die mit dem ersten Anschluß (3) und dem Ausgang des Steuermittels (37) verbunden sind und ein Schaltkontakt (16) umfassen, der zwischen den ersten und zweiten Anschlüssen (3, 5) angeordnet ist.

7. Eine Einrichtung gemäß einem der Ansprüche 3 bis 6,
**dadurch gekennzeichnet, daß**
die Einrichtung zweite Meßmittel (34, 39) umfassen, die mit dem ersten Anschluß (3) verbunden sind und einen Abschalteingang aufweisen, der das erste Abtrenn-Signal empfängt, wobei die zweiten Meßmittel (34, 39) dergestalt ausgestaltet sind, um die Spannung an den Batterien (4) in der Abwesenheit von dem ersten Abtrenn-Signal zu messen.

8. Eine Einrichtung gemäß Anspruch 7,
**dadurch gekennzeichnet, daß**
die zweiten Meßmittel (34, 39) einen Ausgang aufweisen, der mit einem Eingang von dem Logik-Gatter (36) verbunden ist und ausgestaltet sind, ein zweites Abtrenn-Signal an dem Ausgang zu erzeugen, wenn die Spannung an den Batterien (4) unter einem vorbestimmten Schwellwert ist.

9. Eine Einrichtung gemäß einem der Ansprüche 3 bis 8,
**dadurch gekennzeichnet, daß**
die Einrichtung dritte Meßmittel (29, 41) umfaßt, die mit dem zweiten Anschluß (5) verbunden sind und einen Abschalteingang aufweisen, der ein erstes Abtrenn-Signal empfängt und einen Ausgang, der mit einem Eingang von dem Logik-Gatter (36) verbunden ist, wobei die dritten Meßmittel (29, 41) ausgestaltet sind, den Widerstand der Last (2) zu messen und ein drittes Abtrenn-Signal in der Abwesenheit einer Last zu erzeugen.

10. Eine Einrichtung gemäß einem der Ansprüche 3 bis 9, für eine Anwendung für ein Motorfahrzeug, das mit einer kippbaren Kabine ausgestaltet ist,
**dadurch gekennzeichnet, daß**
die Einrichtung einen Überwachungseingang (10) umfaßt, der ein weiteres Abtrenn-Signal empfängt, wenn die Kabine gekippt ist, wobei der Überwachungseingang (10) mit dem Logik-Gatter (36) verbunden ist.

11. Eine Einrichtung gemäß einem der voranstehenden Ansprüche,
**dadurch gekennzeichnet, daß**
die ersten Meßmittel einen Hysterese-Vergleicher (33) umfassen, der einen unteren Schwellwert und einen oberen Schwellwert aufweist, die jeweils Batteriespannungsniveaus an denen die Last (2) von den Batterien abzutrennen ist und wieder an die Batterien (4) anzuschließen ist, darstellen.

12. Eine Einrichtung gemäß einem der Ansprüche 4 bis 11,
**dadurch gekennzeichnet, daß**
das Verzögerungsmittel ein bistabiles Speicherelement (35) umfaßt, mit einem Setzeingang (J), der mit dem ersten Meßmittel (33) verbunden ist, einem Rücksetzeingang (K), der mit dem Zeitgebermittel (24) verbunden ist und einem Ausgang (Q), der mit dem Logik-Gatter (36) verbunden ist.

13. Eine Einrichtung gemäß einem der Ansprüche 7 bis 12,
**dadurch gekennzeichnet, daß**
die zweiten Meßmittel (34, 39) einen Hysterese-Vergleicher (34) umfassen, der einen unteren Schwellwert und einen oberen Schwellwert aufweist, die jeweils Batteriespannungsniveau an denen die Last (2) abzutrennen und wieder an die Batterien (4) anzuschließen ist, darstellen.

## Revendications

1. Dispositif (1) destiné à déterminer l'état de charge d'une batterie (4), en particulier à bord d'un véhicule comportant un moteur, comprenant:
une première borne (3) pour la connexion à la batterie (4);
une seconde borne (5) pour la connexion à une charge (2);
des moyens de commutation (16, 17) qui sont commandés entre un état ouvert et un état fermé, insérés entre lesdites première et seconde bornes (3, 4) et comportant une borne de commande destinée à recevoir un signal d'ouverture;
une unité logique (19) destinée à vérifier l'état de charge lorsque la batterie (4) n'est pas connectée à la charge (2), incluant des premiers moyens de mesure (33) connectés à ladite première borne (3) afin de mesurer la tension sur la batterie; et
un moyen d'attaque (37) connecté à iadite borne de commande desdits moyens de commutation afin d'ouvrir lesdits moyens de commutation (16, 17),
caractérisé en ce que ladite unité logique (19) comprend une entrée (23) destinée à recevoir des impulsions de vérification, un moyen (36) connecté audit moyen d'attaque (37) destiné à activer ledit moyen d'attaque(37) pour ouvrir lesdits moyens de commutation (16, 17) chaque fois que l'unité logique (19) reçoit une desdites impulsions de vérification, et un moyen (35) destiné à produire un signal de sortie représentant la sortie dudit premier moyen de mesure (33) obtenue lorsque lesdits moyens de commutation (16, 17) sont dans l'état ouvert.

2. Dispositif selon la revendication 1, caractérisé en ce qu'il comprend un moyen de temporisation (24) connecté à ladite entrée (23) de ladite unité logique (19) afin d'activer de manière périodique ledit moyen d'attaque (37) et de mettre, par ce moyen, lesdits moyens de commutation (16, 17) dans ledit état ouvert.

3. Dispositif selon la revendication 2, caractérisé en ce que ledit moyen d'activation (36) comprend une porte logique recevant un signal d'entrée issu dudit moyen de temporisation (24) et comporte une sortie connectée à une entrée dudit moyen d'attaque (37) et en ce que ledit moyen d'attaque (37) comporte une sortie connectée à ladite borne de commande desdits moyens de commutation (16, 17) afin de produire ledit signal d'ouverture lors de la réception d'un signal de déconnexion sur son entrée.

4. Dispositif selon la revendication 3, caractérisé en ce que ledit moyen (35) destiné à produire un signal de sortie comprend un moyen à retard comportant une première entrée (J) connectée auxdits premiers moyens de mesure (33), une seconde entrée (K) connectée à une sortie dudit moyen de temporisation (24) et une sortie (Q) connectée à ladite porte logique (36), ledit moyen à retard (35) étant validé par ledit moyen de temporisation afin de produire à la sortie un premier signal de déconnexion et de maintenir ledit premier signal de déconnexion tant que la tension sur la batterie (4) est inférieure à un seuil prédéterminé.

5. Dispositif selon l'une quelconque des revendications 2 à 4, caractérisé en ce que ledit moyen de temporisation (24) comporte une entrée de validation propre (EN) recevant un signal de désactivation pendant une phase de charge de la batterie (4).

6. Dispositif selon la revendication 4 ou 5, caractérisé en ce que lesdits moyens de commutation (16, 17) comprennent un relais (17) dont des entrées d'activation sont connectées à ladite première borne (3) et à la sortie dudit moyen d'attaque (37) et comportant un contact de commutation (16) disposé entre lesdites première et seconde bornes (3, 5).

7. Dispositif selon l'une quelconque des revendications 3 à 6, caractérisé en ce qu'il comprend des deuxièmes moyens de mesure (34, 39) connectés à ladite première borne (3) et comportant une entrée de désactivation recevant ledit premier signal de déconnexion, lesdits deuxièmes moyens de mesure (34, 39) étant adaptés pour mesurer la tension sur la batterie (4) en l'absence dudit premier signal de déconnexion.

8. Dispositif selon la revendication 7, caractérisé en ce que lesdits deuxièmes moyens de mesure (34, 39) comportent une sortie connectée à une entrée de ladite porte logique (36) et sont adaptés pour produire un second signal de déconnexion sur ladite sortie lorsque la tension sur la batterie (4) est inférieure à un seuil prédéterminé.

9. Dispositif selon l'une quelconque des revendications 3 à 8, caractérisé en ce qu'il comprend des troisièmes moyens de mesure (29, 41) connectés à ladite seconde borne (5) et comportant une entrée de désactivation recevant ledit premier signal de déconnexion et une sortie connectée à une entrée de ladite porte logique (36), lesdits troisièmes moyens de mesure (29, 41) étant adaptés pour mesurer la résistance de la charge (2) et pour produire un troisième signal de déconnexion en l'absence de charge.

10. Dispositif selon l'une quelconque des revendications 3 à 9, appliqué à un véhicule à moteur comportant une cabine basculante, caractérisé en ce qu'il comprend une entrée de surveillance (10) recevant un autre signal de déconnexion lorsque la cabine est basculée, ladite entrée de surveillance (10) étant reliée à ladite porte logique (36).

11. Dispositif selon l'une quelconque des revendications précédentes, caractérisé en ce que lesdits premiers moyens de mesure comprennent un comparateur à hystérésis (33) comportant un seuil bas et un seuil haut représentant des niveaux respectifs de tension de batterie pour lesquels la charge (2) doit être déconnectée et reconnectée à la batterie (4).

12. Dispositif selon l'une quelconque des revendications 4 à 11, caractérisé en ce que ledit moyen à retard comprend un élément de mémoire bistable (35) comportant une entrée de mise à un (J) connectée auxdits premiers moyens de mesure (33), une entrée de mise à zéro (K) connectée audit moyen de temporisation (24) et une sortie (Q) connectée à ladite porte logique (36).

13. Dispositif selon l'une quelconque des revendications 7 à 12, caractérisé en ce que lesdits deuxièmes moyens de mesure (34, 39) comprennent un comparateur à hystérésis (34) présentant un seuil bas et un seuil haut représentant des niveaux respectifs de tension de batterie pour lesquels la charge (2) doit être déconnectée et reconnectée à la batterie (4).
